# EUROPEAN PATENT APPLICATION

(11) **EP 4 258 832 A1**
(43) Date of publication of application: **11.10.2023**
(21) Application number: 23164244.8
(22) Date of filing: 27.03.2023
(51) Int. Cl.: H05K 7/14, H01L 23/498

(54) **POWER MODULE HAVING LEADFRAME-LESS SIGNAL CONNECTORS, IN PARTICULAR FOR AUTOMOTIVE APPLICATIONS, AND ASSEMBLING METHOD THEREOF**

(30) Priority: 04.04.2022 IT 202200006617
(71) Applicant: STMicroelectronics S.r.l., 20864 Agrate Brianza (MB) (IT)
(72) Inventor: SAVINO, Sergio, 95125 CATANIA (IT); SALAMONE, Francesco, 95024 ACIREALE (CT) (IT)
(74) Representative: Studio Torta S.p.A.

(57) **Abstract**

Power module (1) packaged in a housing (2) accommodating a carrying substrate (10) forming a plurality of connection regions (14A-14D) of conductive material. An electronic component (15A, 10B) is arranged inside the housing, attached to a connection region (14A, 14B) of the plurality of connection regions (14A-14D). An electrical connector (5), coupled to the electronic component, extends towards the main surface (2A) of the housing (2) and is accessible from the outside of the housing. The electrical connector has a tubular portion forming a pillar (8) fixed to a pin which protrudes from the main surface of the housing. The housing (2) includes a packaging mass (3) of electrically insulating material that embeds the pillar (8) and blocks it therein.

## Description

The present invention relates to a power module having leadframe-less signal connectors, in particular for automotive applications, and to the assembling method thereof.

As known, electric and hybrid propulsion vehicles comprise control electronics of the electric motor. In particular, the control electronics associated with vehicles of this type comprises power modules which may include both power components and signal processing components.

For example, the control electronics associated with electric propulsion generally comprises power phase inverters (so-called inverters) and rectifiers capable of operating at even very high voltages, up to 1200 V.

To electrically couple the modules to each other and to the loads (electric motor and/or vehicle members), the control electronics further generally comprises suitable connection structures, including leads and connection pins of greater dimensions with respect to the signal conduction pins or electronic circuits used in other fields.

The modules are normally enclosed in a packaging body of insulating material, for example molded, or produced using a gel potted technique, wherein a plastic box is filled with an insulating gel and encloses the components, with protruding pins. In both cases, the package has a generally parallelepipedal shape, with two greater surfaces (upper and lower), and four lateral surfaces, of smaller area, with the electrical connection pins protruding therefrom.

The molded power modules are generally arranged on a shaped metal support, called leadframe, which also forms the pins for both the power connection and the signal connection.

This involves a considerable layout complexity to avoid the presence of parasitic components, typically parasitic inductances, as well as requiring an accurate design to ensure the safety isolation distances ("clearance and creepage") and not allowing an efficient use of available spaces.

Furthermore, the overall dimensions of the power module cannot be reduced as desired, due to the need to maintain safety distances.

Furthermore, it is not easy to modify the type of external pins or leads and the way they are connected to the external connection elements (for example to share existing solutions between press-fit connections, soldering, screwing, etc.), depending on the specific design.

The aim of the present invention is to provide a power module which overcomes the drawbacks of the prior art.

According to the present invention, a power module and an assembling method thereof are provided, as defined in the attached claims.

In practice, the power module houses a pillar, typically coupled to the substrate carrying the electronic components of the power module and facing one of the main surfaces (typically, the upper surface) of the package. Alternatively, it may be attached directly to a component of the power module.

The pillar may be attached to the substrate by soldering, with or without filler material (soldering, welding and sintering), or with a conductive glue.

The pillar shape and the package are designed so as to compensate for any manufacturing dimensional variations as well as errors and inaccuracies in mutual positioning between the pillar attaching zone in the power module, the pillar and the pin or other external connection structure, due to process tolerances.

The pillar has an external connection end variable according to the type of connection: for example, the connection end may be flat, for surface mounting or for coupling to external pins by press-fit or soldering; the pillar may be formed in an integral manner with the external pin; the connection end may have a recess configured to allow connection with the external pin by press-fit or by screwing (presence of a thread); the pillar may have structures that prevents its extraction (undercuts, knurls, surface irregularities with protrusions or recesses); and the pillar may have any shape and section, for example it may have a cylindrical shape with a circular section.

The pillar is embedded in the housing 2 so that its lateral sides are completely or almost completely surrounded by and in contact with a packaging mass that blocks the pillar.

For a better understanding of the present invention, some embodiments thereof are now described, purely by way of non-limiting example, with reference to the attached drawings, wherein:
- Figure 1 is a top perspective view of an embodiment of the present power module;
- Figure 2 is a cross-section of a part of the power module of Figure 1, for a surface mounting connection;
- Figure 3 is a cross-section similar to Figure 1, after soldering a pin;
- Figure 4 is a top perspective view of an embodiment of the present power module;
- Figure 5 is a cross-section of a part of the power module of Figure 4;
- Figures 6A-6C, 7A-7C and 8 show cross-sections of variants of the pillar usable with the present power module;
- Figure 9 is a sectional perspective view of a part of the present module, according to an embodiment;
- Figure 10 is a cross-section of a detail of the power module of Figure 9, during a housing molding step;
- Figure 11 is a perspective view of a portion of a power module, according to another embodiment;
- Figure 12 is a cross-section of a detail of the power module of Figure 11, during a housing molding step;
- Figure 13 is a perspective view of a portion of a power module, according to yet another embodiment;
- Figure 14 is a cross-section of a detail of the power module of Figure 13, during a housing molding step;
- Figure 15A shows the coupling between the present power module and external pins by pin holders;
- Figure 15B shows a different coupling between the present power module and external pins by the pin holders;
- Figure 15C shows a different embodiment of a pin coupeable to the present power module;
- Figure 16 is a perspective view of a pin holder usable with the power module of Figure 15;
- Figure 17 is a cross-section of the pin holder of Figure 16;
- Figure 18 is a cross-section of a part of the present power module, for a housing formed using the gel-potted technique;
- Figures 19 and 20 are cross-sections of a part of the present power module, according to another embodiment, in two subsequent manufacturing steps;
- Figures 21 and 22 are cross-sections of a part of the present power module, according to a different embodiment, in two subsequent manufacturing steps; and
- Figures 23 and 24 are cross-sections of a part of the present power module, according to another embodiment, in two subsequent manufacturing steps.

The following description refers to the arrangement shown; consequently, expressions such as "above", "below", "upper", "lower", "right", "left" relate to the attached figures and are not to be interpreted in a limiting manner.

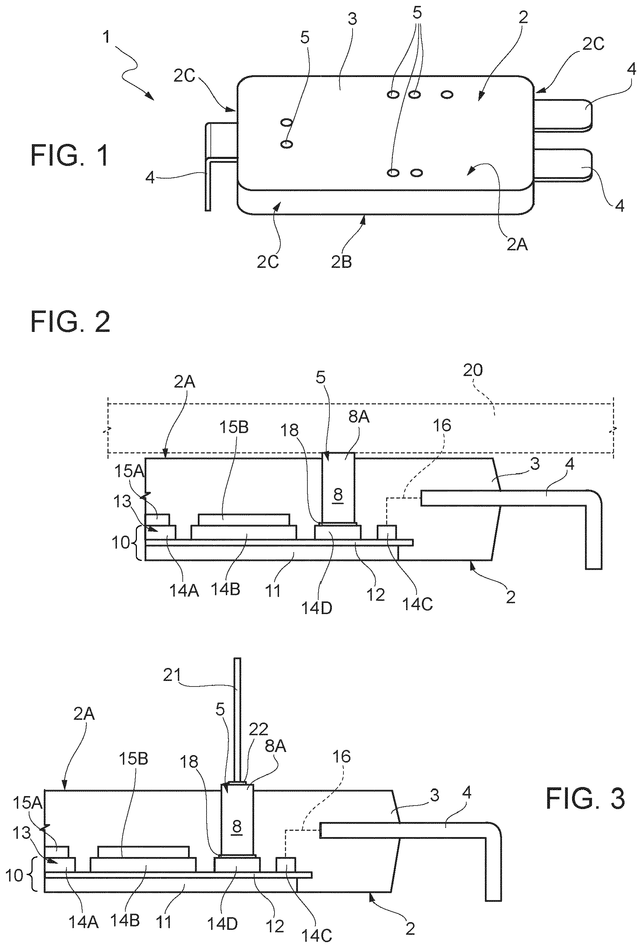

Figure 1 shows a power module 1 packaged in a housing 2 formed by a packaging mass 3, of insulating material, here molded resin.

The housing 2 has a generally parallelepipedal shape, with an upper surface 2A, a lower surface 2B and lateral surfaces 2C.

The housing 2 houses a substrate 10, carrying electronic components (here, two shown, indicated as first and second electronic components 15A, 15B).

Signal or power leads 4 protrude from lateral surfaces 2C of the housing 2, here two lateral surfaces 2C opposite to each other.

Connectors 5, generally signal but, if desired, also power connectors, extend through the housing 2, between the substrate 10 and the upper surface 2A. The connectors 5 may be arranged level, slightly protruding from the upper surface 2A or even slightly recessed with respect thereto.

In the embodiment of Figure 2, the power connectors 5 (only one visible) are formed by pillars 8 attached to a substrate 10.

In detail, in Figure 2 the substrate 10 is formed by a multilayer, for example a DBC (Direct Bonded Copper) substrate or an AMB (Active Metal Brazing) substrate, and comprises a first conductive layer 11, typically of metal such as copper; an intermediate layer 12, insulating, for example of ceramic, arranged on the first conductive layer 11; and a second conductive layer 13, typically of metal such as copper, arranged on the intermediate layer 12.

The second conductive layer 13 is shaped so as to define a plurality of connection islands or regions 14.

A first, a second, a third and a fourth connection region 14A-14D are for example visible in Figure 2.

Here, the first and the second electronic components 15A, 15B, for example power components such as diodes, transistors, thyristors or IGBTs, or packaged discrete components are attached and electrically coupled to the first and, respectively, to the second connection regions 14A, 14B.

The third connection region 14C is coupled to one of the leads 4, in a not visible manner and ideally represented by a dashed line 16. In turn, the third connection region 14C is connected in a manner not shown (for example, through wires or through tracks formed in the second conductive layer 13) to one or both the electronic components 15A, 15B. However, the leads 4 may also be connected directly to the electronic components 15A, 15B.

The fourth connection region 14D carries and is electrically coupled to one of the pillars 8.

In particular, the pillar 8 of Figure 2 may be soldered or glued to the fourth connection region 14D through bonding material 18, for example using a filler material or a conductive glue or adhesive.

The pillar 8 is embedded in the housing 2 so that its lateral sides are almost completely surrounded by and in contact with the packaging mass 3 that blocks the pillar 8 in the housing 2.

As visible from Figure 2, the fourth connection region 14D is flat and the pillar 8 is bonded to the fourth connection region in a planar way, thus simplifying manufacture of the power module.

The pillar 8 here has a cylindrical shape with a circular base and extends from the fourth connection region 14D up to the upper surface 4A of the housing 2, perpendicular to the substrate 10.

In the embodiment of Figure 2, the pillar 8 protrudes slightly from the upper surface 4A with an end 8A.

The pillar 8 has dimensions generally linked to the dimensions of the power module 1. For example, it may have a height comprised between 2 and 7 mm, in particular of about 4.5 mm, and a diameter comprised between 1 and 5 mm, for example of about 2 mm.

In the embodiment of Figures 1 and 2, the end 8A of the pillar 8 is flat and may be used for coupling to user boards, as represented with a dashed line in Figure 2 (board 20).

Alternatively, a pin 21 may be attached to the pillar 8, as shown in Figure 3.

In particular, here, "pin" 21 is intended as a rod-shaped element that allows a current to flow and has a height higher than or equal to that of the pillar 8.

For example, the pins 21 are of metal. They may have a height generally comprised between 2.8 and 14 mm, for example of 8 mm, and a circular section, in particular with a diameter comprised between 0.5 and 1.5 mm, for example of 0.8 mm.

Furthermore, in Figure 3 the pin 21 has a base 22, wider than the rod-shaped portion, attached to the end 8A of the pillar 8. For example, the base 22 may have a thickness comprised between 0.2 and 0.4 mm and a diameter comprised between 1.8 and 3 mm.

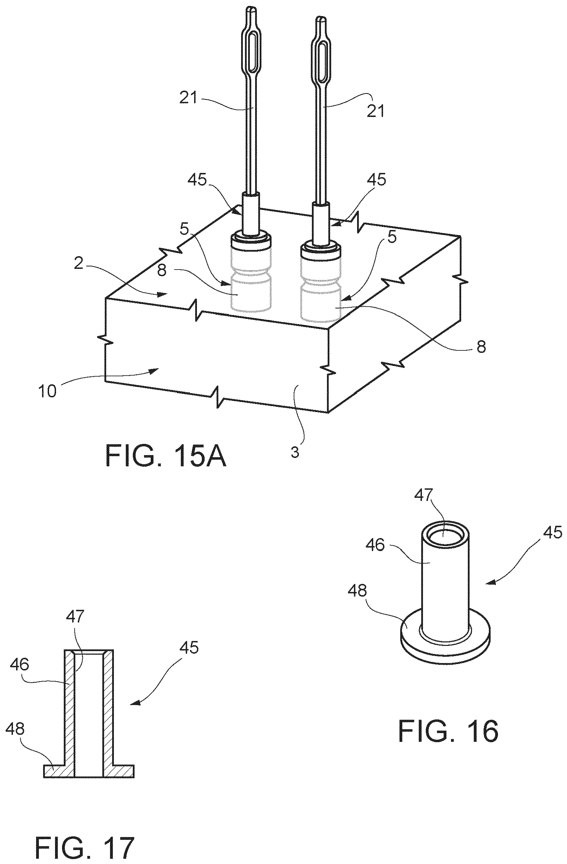

The pins 21 may also have enlarged press-fit-type pin contact zones (not shown in Figure 2, see Figure 15A) in proximity to their distal end (remote from the pillar 8).

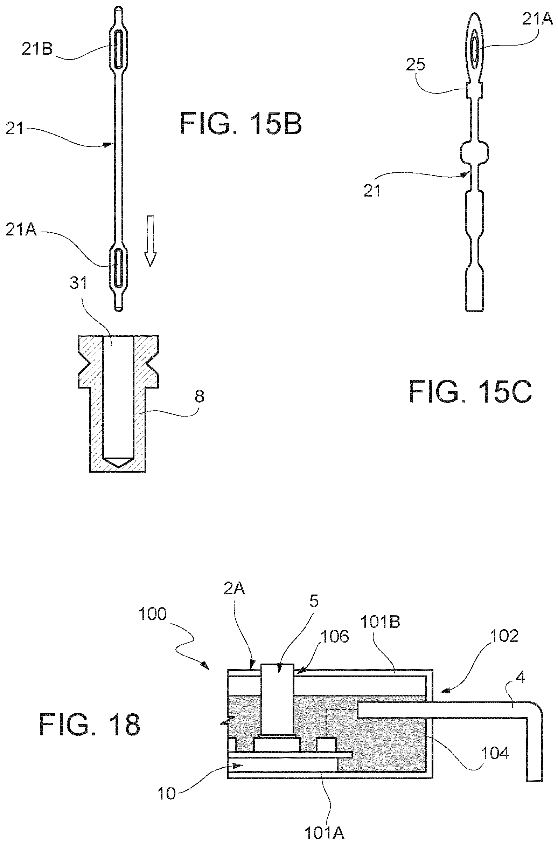

In one embodiment, the pins 21 may have two enlarged press-fit-type contact zones, as shown in Figure 15B and discussed below.

Furthermore, the pins 21 may have stop zones, as shown in Figure 15C and discussed below.

Alternatively, the pins 21 may have any base, for example square (with a side between 0.6 and 3 mm).

In Figure 3, the pillar 8 has a flat end 8A, substantially level with the upper surface 2A of the housing 2.

Furthermore, the pin 21 is attached to the pillar 8 by soldering or gluing. In both cases bonding material (not shown) may be provided between the pin 21 and the pillar 8, for example soldering filler material or a conductive glue.

Alternatively, the pin 21 may be soldered without filler material, for example by ultrasonic welding.

Alternatively, the pin 21 may be press-fit to the pillar 8, as shown in Figure 15B.

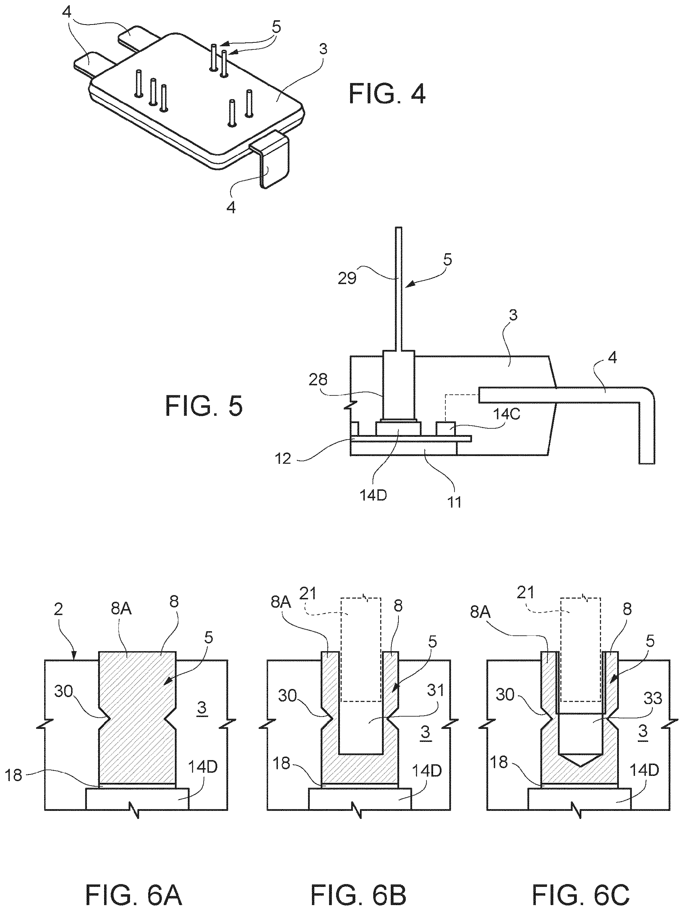

In Figures 4 and 5, the power connectors 5 comprise a bigger area portion, referred to as pillar portion 28, similar to the pillar 8 of Figures 2, 3, and a narrower and longer portion, here called pin portion 29, formed monolithically.

In particular, as visible in Figure 5, the pillar portion 28 extends inside the housing 2 (except for a slightly protruding section) and the pin portion 29 extends from the pillar portion 28, seamlessly, externally to the housing 2. In the embodiment shown, the pillar portion 28 is perpendicular to the upper surface 2A of the housing 2.

The pillar 8 and the pillar portion 28 may have structures which prevent undesired extraction thereof, such as protruding portions, recessing portions, undercuts, knurls, surface irregularities and the like.

For example, Figure 6A shows a pillar 8 of cylindrical shape, having a peripheral groove 30 with annular shape and triangular section, intended to be filled with the resin of the housing 2 which blocks it in position.

In the example shown, the groove 30 is formed at about half the height of the pillar 8 or at a midway point, but it may be arranged at any height.

Furthermore, here it extends throughout the perimeter of the pillar 8, but may be interrupted.

Alternatively, the surface of the pillar 8 may form one or more protruding annular structures, blocking the pillar 8 inside the packaging mass 3 forming the housing 2. Figure 6B shows a pillar 8 having the groove 30 and provided with an axial recess 31 extending from the end 8A towards the inside of the pillar 8. In this solution, as shown with dashed line, the pin 21 may be press-fit into the axial recess 31 and blocked, without the need to use glues and/or soldering.

Figure 6C shows a pillar 8 having the groove 30 and provided with a threaded hole 33 which extends axially from the end 8A towards the inside of the pillar 8. In this case, the pin 21 may be screwed to the pillar 8, also here without glues and/or soldering.

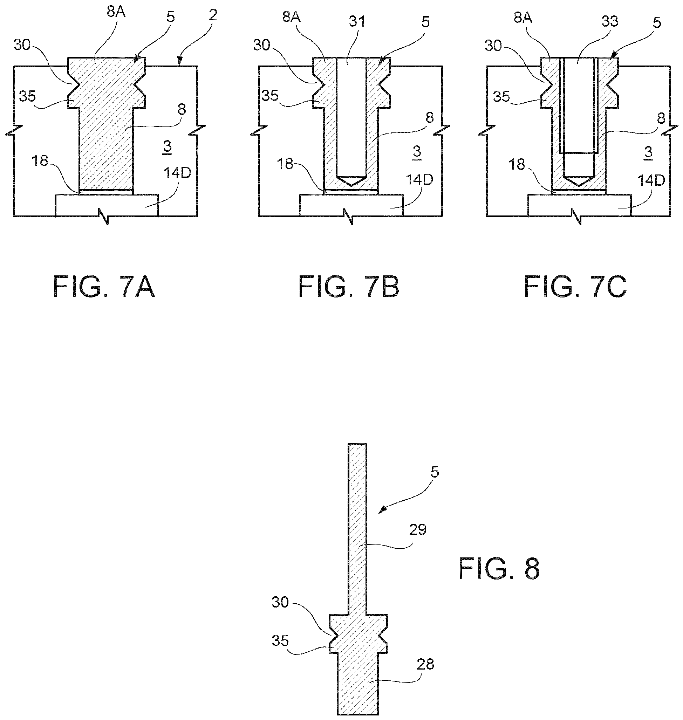

Figure 7A shows a pillar 8 having an enlarged head 35 and the groove 30 is formed in the enlarged head 35 of the pillar 8.

Alternatively, the surface of the enlarged head 31 may form knurls or protruding and/or recessing structures which block it inside the housing 2.

Figure 7B shows a pillar 8 having the enlarged head 35 and the groove 30 as in Figure 7A, and also an axial recess 31 similar to Figure 6B. Also in this solution, therefore, the pin 21 may be press-fit into the axial recess 31.

Figure 7C shows a pillar 8 provided with the enlarged head 35 and the groove 30 as in Figure 7A, and also with a threaded hole 33 as in Figure 6C. In this solution, therefore, the pin 21 may be screwed to the pillar 8.

Figure 8 shows a power connector 5 comprising the pillar portion 28 and the pin portion 29, that are monolithic, as in Figure 5, wherein the pillar portion 28 also has the enlarged head 35 and the groove 30 as in Figure 7A.

Alternatively, similarly to Figure 6A, the power connector 5 of Figure 8 may have only the groove 30, with no enlarged head 35, or other type of anti-extraction structures, as described above.

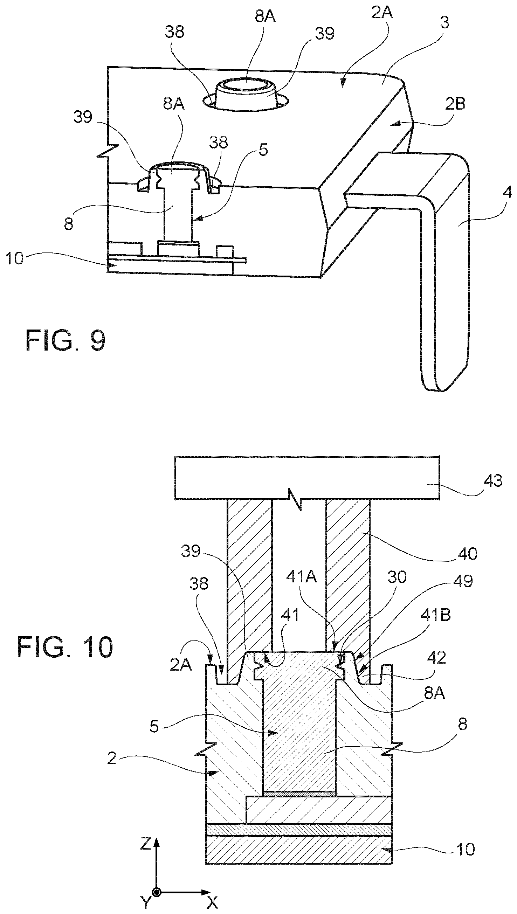

Figures 9 and 10 show a portion of a power module 1 having power connectors 5 of the type shown in Figure 7A, with a flat end 8A, wherein the housing 2 has measures to compensate for any dimension differences with respect to design values, as well as misalignments and positioning inaccuracies due to manufacturing and/or assembling tolerances.

In detail, in Figures 9 and 10, the housing 2 has a peripheral slot 38 surrounding the end 8A of the pillar 8.

The peripheral slot 38 includes an inclined surface 49 (Figure 10) that is at an angle with respect to the upper surface 2A of the housing 2 and protrudes with respect thereto.

The peripheral slot 38 here extends to a short distance from the end 8A, so that this end 8A is surrounded by an annular portion 39 of the material of the housing 2, wherein the annular portion 39 is in turn surrounded by the peripheral slot 38.

In Figure 9, both the end 8A of the pillar 8 and the annular portion 39 protrude with respect to the upper surface 2A of the housing 2, due to the higher height of the pillar 8.

This configuration allows any height tolerances of the pillar 8 to be compensated, as explained hereinbelow with reference to Figure 10.

In the embodiment of Figures 9 and 10, the pillar 8 has the groove 30 near the end 8A.

Figure 10 shows a portion of the power module 1 during molding. In this step, the power module 1 is inserted into a mold (represented only schematically and indicated by 43) which comprises one or more ejectors 40, one for each power connector 5.

In the case shown, the ejector 40 has a non-flat head surface 41, with a bigger area than the end 8A of the pillar 8. In the illustrated example, the ejector 40 is hollow, but it may be solid; the following dimensional considerations are presented as if the ejector 40 were solid.

The head surface 41 of the ejector 40 has a central zone 41A that is plane and a peripheral zone 41B protruding with respect to the central zone 41A and forming a step 42. The central zone 41A (typically circular, in case of pillar 8 with a circular section) has a greater area than the end 8A of the pillar 8, so as to rest flat on this end 8A and protrude laterally thereto with the step 42 arranged to partially surround, at a distance, the end 8A of the pillar 8.

Consequently, when the material of the housing 2 (for example resin), in a fluid phase, is injected into the mold 43, the resin covers the support 10 and the electronic components 15A, 15B, surrounds each pillar 8 and also gets into the gap existing between the step 42 of the ejector 40 and the end 8A of the pillar 8, creating the peripheral slot 38 and the annular portion 39.

Assuming that the power module 1 is arranged, with respect to a Cartesian coordinate system XYZ, with the axis of the pillar 8 directed parallel to axis Z, this solution allows compensation of any height inaccuracies of the pillar 8 or of the underlying layers of the substrate 10 (inaccuracies along the axis Z as in Figure 9) as well as any positioning inaccuracies of the pillar 8 or ejector 40 with respect to the axes X and Y.

In fact, the ejector 40 is rested on the end 8A of the pillar 8 with its central zone 41A, planar, and held in position by mechanical or pneumatic springs (not shown) capable of compensating for height errors of the end 8A of the pillar 8; the dimension of the central zone 41A allows compensation of any positioning errors along the axis X and/or the axis Y, as well as any small dimensional thickness tolerances, ensuring that the resin does not extend above the end 8A or form undesired peripheral burrs.

It should be noted that the "external" portion of the groove 38, not occupied by the ejector 40, is due to the shaping of the mold.

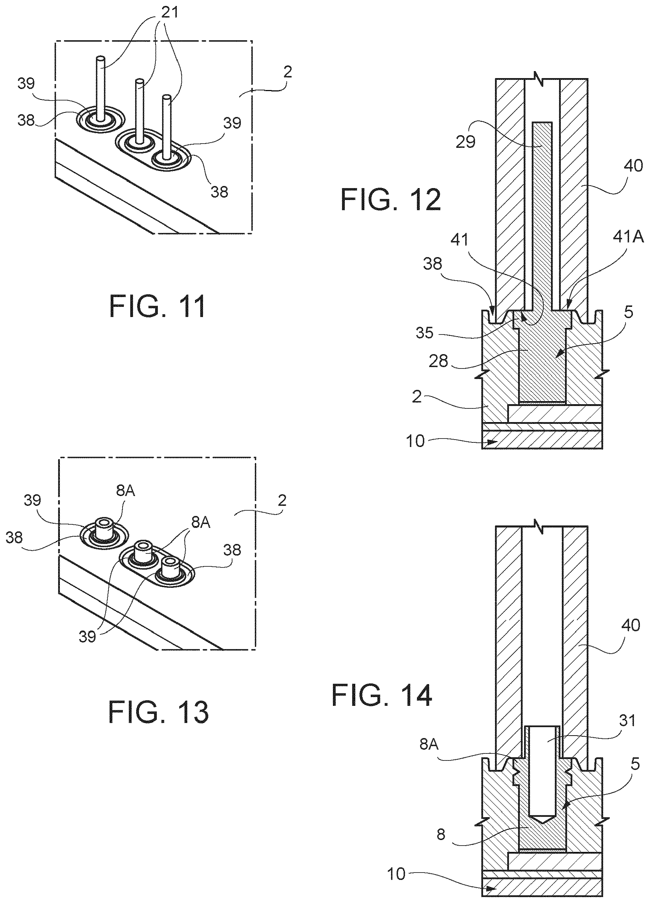

Figures 11 and 12 show the step of forming the housing 2 for a power connector 5 having an integral pin portion 29. In this case, the ejector 40 is again hollow, to house the pin portion 29 of the power connector 5. Here, the central zone 41A of the head surface 41 abuts against the shoulder formed by the enlarged head 35 of the pillar portion 28.

Figures 13 and 14 show the step of forming the housing 2 for a power connector 5 having a central hole, here the axial recess 31 of Figures 6B and 7B, but also valid in case of the threaded hole 33 of Figures 6C and 7C. In this case, the arrangement shown ensures that the resin does not enter the axial recess 31 or the threaded hole 33.

Figure 15A shows a solution wherein the pins 21 are attached to the pillars 8 through so-called pin holders 45 and have an end 21A having an enlarged zone (for example formed by axial bumps) so as to allow a press-fit connection with a connection support, such as a printed circuit board PCB.

In detail, and as shown in Figures 16 and 17, each pin holder 45 is formed by a tubular body 46, here of cylindrical shape, having a through axial cavity 47 and provided, on one of its bases, with a flange 48.

Each pin holder 45 is attached to the end 8A (not visible in Figure 15) of a respective pillar 8 through ultrasonic welding or laser welding, without filler material.

The pins 21 are then each interference-fit into a respective pin holder 45.

Figure 15B shows a pin 21 having two enlarged ends 21A, 21B, for press-fit connection. For example, the pin 21 of Figure 15B may be connected, with one of the two enlarged ends 21A, 21B, here a first enlarged end 21A, to the pillar 8 (as shown by the arrow) and with the other of the two enlarged ends 21A, 21B, for example a second enlarged end 21B, to a support such as a PCB.

Figure 15C shows a pin 21 having an enlarged end 21A intended for press-fit into the axial recess 31 of the pillar 8 and a stop 25, next to the enlarged end 21A. The stop 25 has a greater width than the enlarged end 21A (and the axial recess 31) and has the purpose of preventing the pin from excessively penetrating into the axial recess 31 of the pillar 8.

Figure 18 shows a power module 100 packaged according to the gel-potted technique.

In detail, the power module 100 comprises a housing 102 formed by two half-shells (first half-shell 101A, second half-shell 101B) of insulating material, for example plastic.

A gel material 104 is contained inside the half-shells 101A, 101B and blocks the support 10 and the electronic components (not visible in Figure 18) in position.

Here, the support 10 is attached to the first half-shell 101A and the power connector 5 extends through a hole 106 in the second half-shell 101B.

The power connector 5 shown in Figure 18 is formed by the pillar 8 in the configuration shown in Figures 2 and 3; however, it may also be provided in any of the configurations of Figures 4-17 and, in particular, may comprise a pillar portion 28 and a pin portion 29, monolithic to each other, as in Figure 5 or 8, or comprise a pin holder, similar to the component 45 of Figures 15-17.

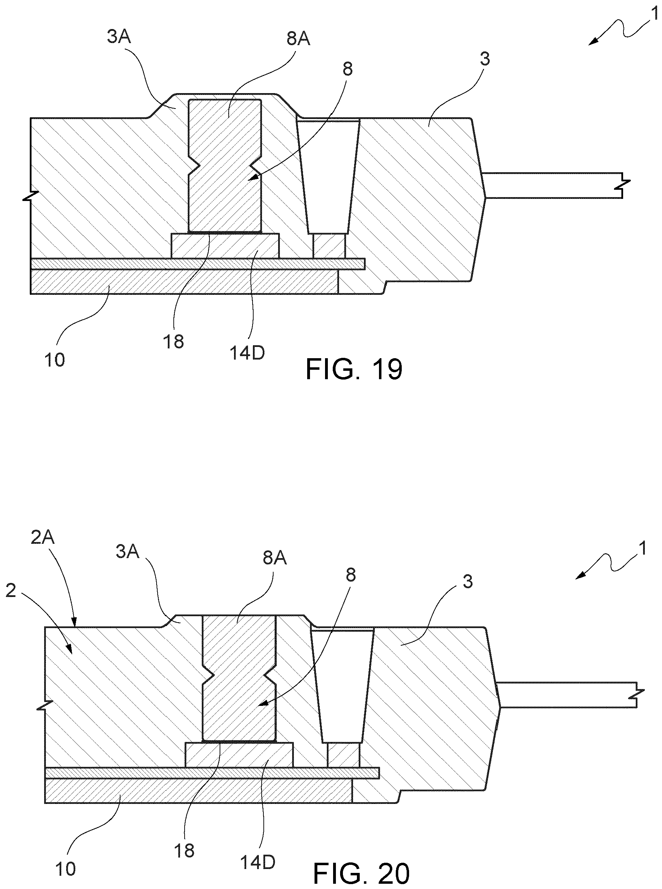

Figures 19 and 20 show two manufacturing steps of the power module 1, according to an embodiment; here, the pillar 8 of Figure 6A is used.

In Figure 19, the pillar 8 has already been soldered or glued to the fourth connection region 14D through bonding material 18, and the packaging mass 3 has already been molded.

Here, the mold (not shown) is such that the packaging mass 3 covers the end 8A of the pillar 8 and forms a protruding portion 3A.

The protruding portion 3A is then thinned to expose the pillar 8 and the pillar 8 is shortened by a grinding operation.

Thereby, the end 8A of the pillar 8 is flush with the remaining part of protruding portion 3A of the packaging mass 3 (Figure 20).

This solution may be applied to pillars of different shape, for example the embodiments of Figures 2, 3, 7A.

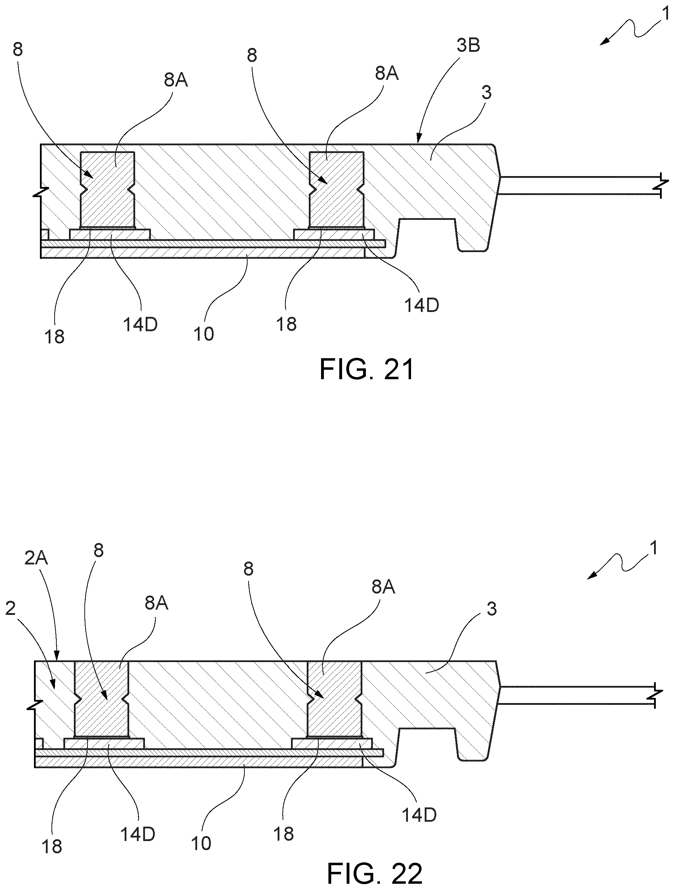

Figures 21 and 22 show two different manufacturing steps of the power module 1, according to a different embodiment; here, the pillar 8 of Figure 6A is used.

In Figure 21, the pillar 8 has already been soldered or glued to the fourth connection region 14D through bonding material 18, and the packaging mass 3 has already been molded.

In Figure 21, the mold is such that the packaging mass 3 covers the end 8A of the pillar 8 without forming protruding portions. In other words, the packaging mass 3 has a flat upper surface 3B.

The packaging mass 3 is then ground, from the flat upper surface 3B, to expose the pillar 8; then the upper portion of the pillar 8 and the upper portion of the packaging mass 3 are ground, so that the end 8A of the pillar 8 is flush with the packaging mass 3 (Figure 22).

Also this solution may be applied to pillars of different shape, for example the embodiments of Figures 2, 3, 7A.

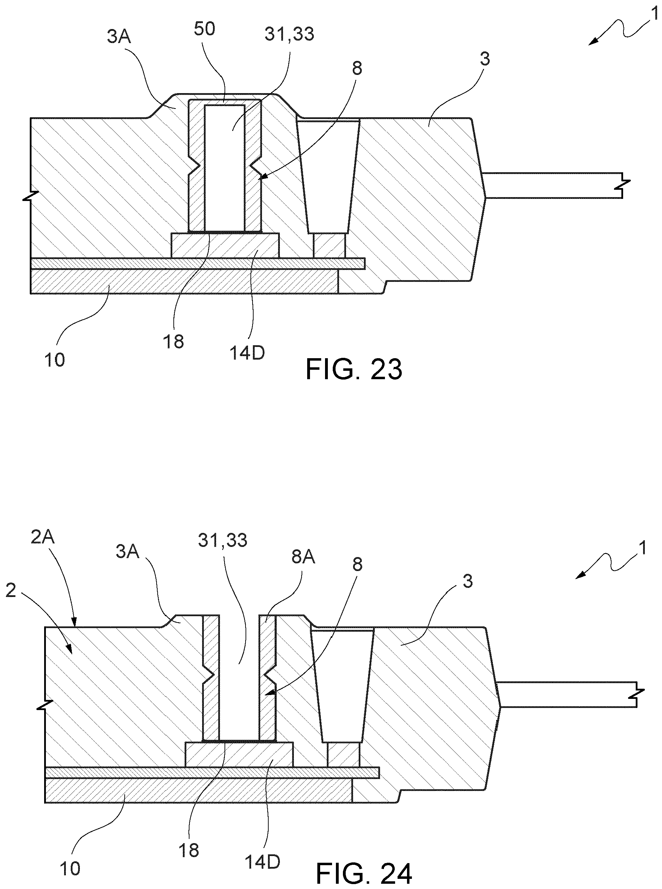

Figures 23 and 24 show two different manufacturing steps of power module 1, according to an another embodiment; here, holed pillars, such as pillars 8 of Figures 6B, 6C, 7B, 7C, 15B, are used.

In Figure 23, the pillar 8 is soldered or glued to the fourth connection region 14D turned upside down, so that the axial recess 31 or threaded hole 33 faces the substrate 10 and a closed base 50 of the axial recess 31 or threaded hole 33 is arranged far from the substrate 10. Bonding material 18 is used.

In figure 23, the packaging mass 3 has already been molded and covers the closed base 50 of the pillar 8. As in the embodiment of Figures 19-20, the mold (not shown) is such that the packaging mass 3 completely covers the pillar 8. In particular, here, the packaging mass 3 covers the closed base 50 of the pillar 8 and forms the protruding portion 3A.

Here, the packaging mass 3 and the pillar 8 are ground until completely removing the closed base 50 and form the end 8A of the pillar 8. Thereby, Figure 24, the axial recess 31 or threaded hole 33 is open to the outside and the end 8A of the pillar 8 is flush with the packaging mass 3.

Thereby, no resin or molding material may enter the axial recess 31 or threaded hole 33 during molding.

In the alternative to the embodiment of Figures 23, 24, analogously to Figures 21, 22, the packaging mass 3 may have a flat upper surface and no protruding portions are provided.

The described power module and its assembling method have numerous advantages.

In particular, exploiting the upper surface 2A of the housing 2, 102 for signal/power electrical connection of the electric components allows the external surface of the housing to be to efficiently exploited, by simplifying the complexity of the connections at the substrate 10 level, reducing the parasitic inductances and the dimensions of the power module, while allowing the critical distances and the desired creepage to be maintained based on expected working voltages.

The solution is easily adaptable to pins of different type and to the desired bonding type (press-fit, soldering/welding).

The power connectors 5 are inexpensive and the assembling operations are simple, so that the power module 1, 100 has costs comparable with the known solutions.

Finally, it is clear that modifications and variations may be made to the power module and to the assembling method described and illustrated herein without thereby departing from the scope of the present invention, as defined in the attached claims.

For example, the different embodiments described may be combined to provide further solutions.

Furthermore, if allowed by the electronic components, the power connector 5 may be attached directly to contact pads of the devices internal to the power module.

In the embodiments of Figures 19-24, thinning of the packaging mass 3 and shortening of the pillar 8 may be done by any other technique allowing removal of material, for example milling.

Thinning of the packaging mass 3 may stop at the pillar 8, without shortening the latter.

Examples of the present disclosure may be summarized as follows.

Example 1. A power module (1; 100), comprising:
a housing (2; 102) having a main surface (2A) and lateral surfaces (2C);
a carrying substrate (10), inside the housing, the carrying substrate forming a plurality of connection regions (14A-14D) of conductive material;
an electronic component (10A, 15B), inside the housing, attached to a first connection region (14A, 14B) of the plurality of connection regions (14A-14D); and
an electrical connector (5), coupled to the electronic component (15A, 15B) or to a second connection region (14C) of the plurality of connection regions,
the electrical connector (5) extending towards the main surface (2A) of the housing (2; 102), transversely thereto, and being accessible from the outside of the housing.

Example 2. The power module according to example 1, wherein the electrical connector (5) comprises a pillar element (8; 28) having one end (8A) facing the main surface (2A) of the housing.

Example 3. The power module according to the preceding example, wherein the pillar element (8; 28) has a solid cylindrical shape.

Example 4. The power module according to the preceding example, wherein the electrical connector (5) further comprises a rod-shaped element (21) soldered to the end (8A) of the pillar element (8) and extending from the main surface (2A) of the housing (2; 102) to the outside of the housing, in prosecution of the pillar element (8).

Example 5. The power module according to example 2 or 3, wherein the electrical connector (5) further comprises a pin holder (45) formed by an axially holed cylindrical body and provided with a flange end (48), the flange end being attached to the end (8A) of the pillar element (8) and extending from the main surface (2A) of the housing (2; 102) towards the outside thereof, in continuation of the pillar element (8).

Example 6. The power module according to the preceding example, wherein the electrical connector (5) further comprises a rod-shaped element (21) press-fit in the pin holder (45).

Example 7. The power module according to example 2, wherein the pillar element (8) has a cylindrical shape and comprises an axial hole (31).

Example 8. The power module according to the preceding example, wherein the electrical connector (5) further comprises a rod-shaped element (21) press-fit or screwed into the axial hole (31) and extending in prosecution of the pillar element (8).

Example 9. The power module according to example 2 or 3, wherein the electrical connector (5) further comprises a pin portion (29) monolithic with the pillar element (28), the pin portion (29) being rod-shaped and extending externally to the housing (2; 102) in prosecution of the pillar element (28).

Example 10. The power module according to any of examples 2-9, wherein the pillar element (8; 28) has anti-extraction characteristics (30; 35), the anti-extraction characteristics comprising protruding and/or recessing structures (21A) and possibly stops (15).

Example 11. The power module according to any of examples 2-10, wherein the housing (2) comprises a packaging mass (3) that is electrically insulating and forms the upper surface (2A) and the lateral surfaces (2C), wherein a recess (38) in the upper surface surrounds the end (8A) of the pillar element (8; 28).

Example 12. The power module according to any of examples 2-10, wherein the housing (102) comprises a box housing an insulating gel (104) and forms a gel-potted package, wherein the box comprises a hole (106) configured to allow the end (8A) of the pillar element (8) to pass through.

Example 13. The power module according to any of the preceding examples, wherein the electronic component (15A) forms a first electronic component and the housing (2; 102) houses a second electronic component (15B), the power module further comprising electrical leads (4) extending from or on the lateral surfaces (3C) of the housing and electrically coupled to external connection regions (14C) formed by the carrying substrate (10) and electrically coupled to the first and/or the second electronic component (15A, 15B).

Example 14. An assembling method for a power module, comprising:
forming a carrying substrate (10) having a plurality of connection regions (14A-14D) of conductive material;
attaching an electronic component (15A, 15B) to a first connection region (14C) of the plurality of connection regions;
attaching an electrical connector (5) to a second connection region (14D) of the plurality of connection regions or to the electronic component;
forming a housing (2; 102) having a main surface (2A) and lateral surfaces (2C) and enclosing the carrying substrate, the electronic component and the electrical connector so that the electrical connector extends up to the main surface of the housing and is accessible from the outside of the housing.

Example 15. The assembling method according to the preceding example, wherein forming a housing (2) comprises molding packaging insulating material (3) with a mold (43) including an ejector (40) having a head surface (41), wherein the head surface (41) of the ejector has a central zone (41A) configured to abut against the electrical connector (5), and a peripheral zone (41B), of a greater area than the central zone (41A) and the electrical connector (5) and configured to be arranged laterally to the electrical connector (5).

Example 16. The assembly method according to example 14, wherein the electrical connector (5) comprises a pillar (8), wherein forming a housing (2) comprises molding packaging insulating material (3) completely covering the pillar; and removing the packaging insulating material (3) from above the pillar, thereby the pillar has an exposed end flush with the main surface (2A) of the housing (2).

Example 17. The assembling method according to the preceding example, wherein removing the packaging insulating material (3) comprises grinding.

## Claims

1. A power module (1; 100), comprising:
a housing (2; 102) including a packaging mass (3) of electrically insulating material, the housing having a main surface (2A) and lateral surfaces (2C);
a carrying substrate (10), inside the housing, the carrying substrate forming a plurality of connection regions (14A-14D) of conductive material;
an electronic component (10A, 15B), inside the housing, attached to a first connection region (14A, 14B) of the plurality of connection regions (14A-14D); and
an electrical connector (5), coupled to the electronic component (15A, 15B) or to a second connection region (14C) of the plurality of connection regions,
the electrical connector (5) extending towards the main surface (2A) of the housing (2; 102), transversely thereto, and being accessible from the outside of the housing,
2wherein the electrical connector (5) comprises a pillar element (8; 28) having one end (8A) facing the main surface (2A) of the housing, the pillar element (8; 28) being embedded in the packaging mass (3) of the housing (2).

2. The power module according to the preceding claim, wherein the pillar element (8; 28) has a solid cylindrical shape.

3. The power module according to the preceding claim, wherein the electrical connector (5) further comprises a rod-shaped element (21) soldered to the end (8A) of the pillar element (8) and extending from the main surface (2A) of the housing (2; 102) to the outside of the housing, in prosecution of the pillar element (8).

4. The power module according to claim 1 or 2, wherein the electrical connector (5) further comprises a pin holder (45) formed by an axially holed cylindrical body and provided with a flange end (48), the flange end being attached to the end (8A) of the pillar element (8) and extending from the main surface (2A) of the housing (2; 102) towards the outside thereof, in continuation of the pillar element (8).

5. The power module according to the preceding claim, wherein the electrical connector (5) further comprises a rod-shaped element (21) press-fit into the pin holder (45).

6. The power module according to claim 1, wherein the pillar element (8) has a cylindrical shape and comprises an axial hole (31).

7. The power module according to the preceding claim, wherein the electrical connector (5) further comprises a rod-shaped element (21) press-fit or screwed into the axial hole (31) and extending in prosecution of the pillar element (8) .

8. The power module according to any of the preceding claims, wherein the pillar is flush with the main surface (2A) of the housing (2; 102).

9. The power module according to claim 1 or 2, wherein the electrical connector (5) further comprises a pin portion (29) monolithic with the pillar element (28), the pin portion (29) being rod-shaped and extending externally to the housing (2; 102) in prosecution of the pillar element (28).

10. The power module according to any of the preceding claims, wherein the pillar element (8; 28) has anti-extraction characteristics (30; 35), the anti-extraction characteristics comprising protruding and/or recessing structures (21A) and possibly stops (15).

11. The power module according to any of the preceding claims, wherein the packaging mass (3) forms the upper surface (2A) and the lateral surfaces (2C) of the housing (2), wherein a recess (38) in the upper surface surrounds the end (8A) of the pillar element (8; 28).

12. The power module according to any of the preceding claims, wherein the electronic component (15A) forms a first electronic component and the housing (2; 102) houses a second electronic component (15B), the power module further comprising electrical leads (4) extending from or on the lateral surfaces (3C) of the housing and electrically coupled to external connection regions (14C) formed by the carrying substrate (10) and electrically coupled to the first and/or the second electronic component (15A, 15B).

13. An assembling method for a power module, comprising:
forming a carrying substrate (10) having a plurality of connection regions (14A-14D) of conductive material;
attaching an electronic component (15A, 15B) to a first connection region (14C) of the plurality of connection regions;
attaching an electrical connector (5) comprising a pillar element (8; 28) to a second connection region (14D) of the plurality of connection regions or to the electronic component;
forming a housing (2; 102) including a packaging mass (3) of electrically insulating material, the housing having a main surface (2A) and lateral surfaces (2C) and enclosing the carrying substrate, the electronic component and the electrical connector so that the electrical connector extends up to the main surface of the housing and is accessible from the outside of the housing,
wherein forming a housing (2) comprises molding packaging insulating material (3) embedding the pillar element (8; 28) so that the pillar element (8; 28) is blocked by the insulating material (3) and has one end (8A) facing the main surface (2A) of the housing.

14. The assembling method according to the preceding claim, wherein molding packaging insulating material (3) comprises using a mold (43) including an ejector (40) having a head surface (41), wherein the head surface (41) of the ejector has a central zone (41A) configured to abut against the electrical connector (5), and a peripheral zone (41B), of a greater area than the central zone (41A) and the electrical connector (5) and configured to be arranged laterally to the electrical connector (5).

15. The assembly method according to claim 13, wherein molding packaging insulating material (3) comprises completely cover the pillar; and wherein forming a housing (2) further comprises removing the packaging insulating material (3) from above the pillar, in particular by grinding or milling, thereby the pillar has an exposed end flush with the main surface (2A) of the housing (2).
